Europäisches Patentamt

European Patent Office

Office européen des brevets

(11) Veröffentlichungsnummer: **0 260 483**
**A2**

(12) **EUROPÄISCHE PATENTANMELDUNG**

(21) Anmeldenummer: **87112271.9**

(22) Anmeldetag: **25.08.87**

(51) Int. Cl.⁴: **H05K 3/44**

(30) Priorität: **16.09.86 DE 3631426**

(43) Veröffentlichungstag der Anmeldung:
**23.03.88 Patentblatt 88/12**

(84) Benannte Vertragsstaaten:
**CH FR IT LI NL SE**

(71) Anmelder: **KOLLMORGEN CORPORATION**
**10 Mill Pond Lane**
**Simsbury, CT 06070(US)**

(72) Erfinder: **Karla, Helmut,**
**Am Hollaender See, 52,**
**D-4170 Geldern 1,(DE)**

(74) Vertreter: **Königseder, geb. Egerer, Claudia**
**Zugspitzstrasse 65**
**D-8104 Grainau(DE)**

(54) **Leiterplatten mit plattenförmigem Metallkern und Verfahren zu deren Herstellung.**

(57) Die Erfindung betrifft Metallkern-Leiterplatten, deren Metallkern mindestens eine Oberfläche aufweist, die mit Kanälen versehen ist, die den Luftaustritt aus Lochungen beim Beschichten mit Isolierstoff und damit die blasenfreie Füllung der Lochungen bewirken, sowie auf Verfahren zum Herstellen solcher Metallkern-Leiterplatten.

FIG. 3

# LEITERPLATTEN MIT PLATTENFÖRMIGEM METALLKERN UND VERFAHREN ZU DEREN HERSTELLUNG

Die Erfindung betrifft einen plattenförmigen Metallkern aufweisende Leiterplatten und ein Verfahren zu deren Herstellung.

Zum Herstellen der genannten Leiterplatten wurde bereits vorgeschlagen, einen plattenförmigem Metallkern zunächst mit Lochungen zu versehen, sodann durch Auflaminieren von Epoxy-Prepregs beide Seiten des Metallkerns unter gleichzeitigem Einbringen von Epoxyd-Harz in die Lochungen mit einer Isolierstoff-Schicht zu bedecken, anschließend zweite Lochungen mit einem kleineren Durchmesser herzustellen und so die Lochungen mit einem Isolierstoff-Belag zu versehen, um anschließend die Lochwandungen mit einer vom Metallkern isolierten Metallschicht zu versehen.

Bislang war es nicht möglich, sicherzustellen, daß alle Lochungen vollständig und blasenfrei mit Isolierstoff gefüllt werden. Unter ungünstigen Umständen führt dies zu Defekten im Isolierstoff-Belag und damit zu Kurzschlüssen zwischen Metallkern und Lochwand-Metallbelag bzw. zu Schwachstellen, die im späteren Betrieb zu Ausfällen führen.

Aufgabe der Erfindung ist es, durch Abfuhr der Luft in den Lochungen für eine vollständige und damit blasenfreie Füllung mit Isolierstoff zu sorgen. Damit wird es möglich, Metallkern-Leiterplatten wirtschaftlich und in ausgezeichneter Qualität herzustellen. Letzteres ist insbesondere auch deshalb von Bedeutung, weil derartige Leiterplatten auf Gebieten angewendet werden, wo hohe Funktionszuverlässigkeit gefordert werden muß.

Diese Aufgabe wird durch die im kennzeichnenden Teil des Anspruchs 1 angegebenen Merkmale gelöst. Vorteilhafte Weiterbildungen ergeben sich aus den Unteransprüchen. Die Metallkern-Leiterplatten nach der Erfindung zeichnen sich dadurch aus, daß zumindest eine der Oberflächen des Metallkerns mit einem Netz von Kanälen versehen ist, die vorteilhaft so angeordnet sind, daß jede Lochung auf ihrem äußeren Umfang mit einer Mehrzahl von Kanälen in Verbindung steht. Sie sind mit Isolierstoff bedeckt. Das Verfahren nach der Erfindung ist dadruch gekennzeichnet, daß zunächst zumindest eine der Seiten eines plattenförmigen Metallkerns mit einem Netz von Kanälen versehen wird, daß sodann erste Lochungen hergestellt werden, um anschließend den Metallkern mit einer Isolierstoff-Schicht zu versehen, die gleichzeitig die Lochungen ausfüllt, wobei die Kanäle zur Abfuhr der Luft aus den Lochungen dienen, wodurch eine blasenfreie Füllung erzielt wird, daß sodann die mit Isolierstoff gefüllten Lochungen mit zweiten Lochungen versehen werden, wobei der Durchmesser der zweiten Lochungen geringer ist als jener der ersten Lochungen, so daß eine Isolierstoff-Schicht auf den Lochwandungen erhalten bleibt.

Vorteilhafterweise werden die Kanäle netzartig angeordnet und der Abstand zwischen benachbarten Kanälen so bemessen, daß die ersten Lochungen auf ihrem Umfang mit einer Mehrzahl von Kanälen in Verbindung stehen.

Nach einer Ausführungsform werden die Kanäle gitterartig angeordnet.

In der bevorzugten Ausführungsform wird die Oberfläche des Metallkerns in einem Laminiervorgang mit Prepreg unter Druck und Hitze beschichtet, wobei gleichzeitig die zuvor angebrachten ersten Lochungen unter Verdrängung der in diesen befindlichen Luft über die Kanäle mit Isolierstoff gefüllt werden.

In einer weiteren Ausführungsform der Verfahrens nach der Erfindung wird zunächst die oder eine der beiden mit Kanälen versehene(n) Seite(n) einer Metallkernplatte mit dem Preßblech abgedeckt und von der anderen Seite ein Epoxy-Prepreg unter gleichzeitigem Füllen der Lochungen auflaminiert. Damit ermöglichen die auf der dem Preßblech zugewandten Seite befindlichen Kanäle allein oder bevorzugt das Entweichen der Luft aus den Lochungen. Anschließend wird ein Prepreg zum Beschichten der zweiten Seite der Metallkernplatte auf diese auflaminiert.

Nachstehend wird die Erfindung anhand der Figuren näher beschrieben.

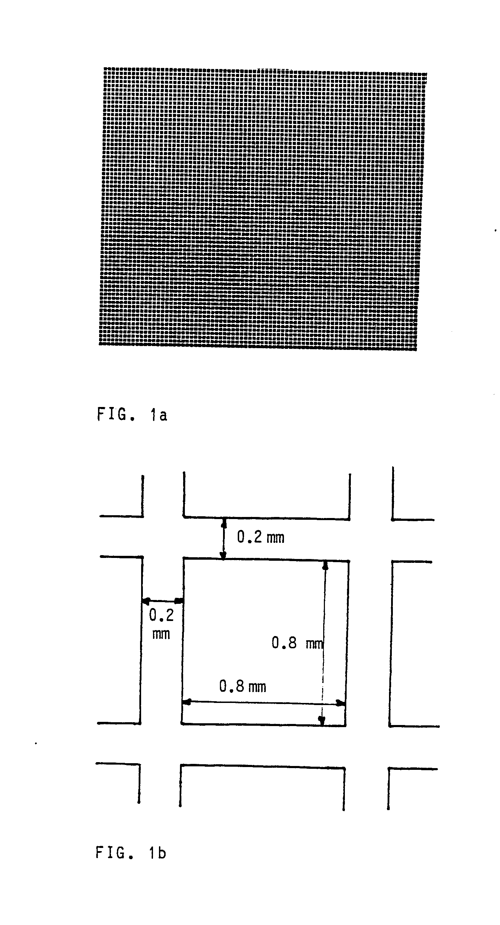

Fig. 1a zeigt die mit einem Netz von Kanälen versehene Oberfläche einer Metallkernplatte.

Fig. 1b gibt die bevorzugten Dimensionen der Kanäle und der Zwischenräume zwischen diesen an.

Danach beträgt die Breite der in einem orthoginalen Raster angeordneten Kanäle 0.2 mm und der Abstand zwischen benachbarten Kanälen 0.8 mm. Die Kanaltiefe kann beispielsweise 0.035 mm betragen.

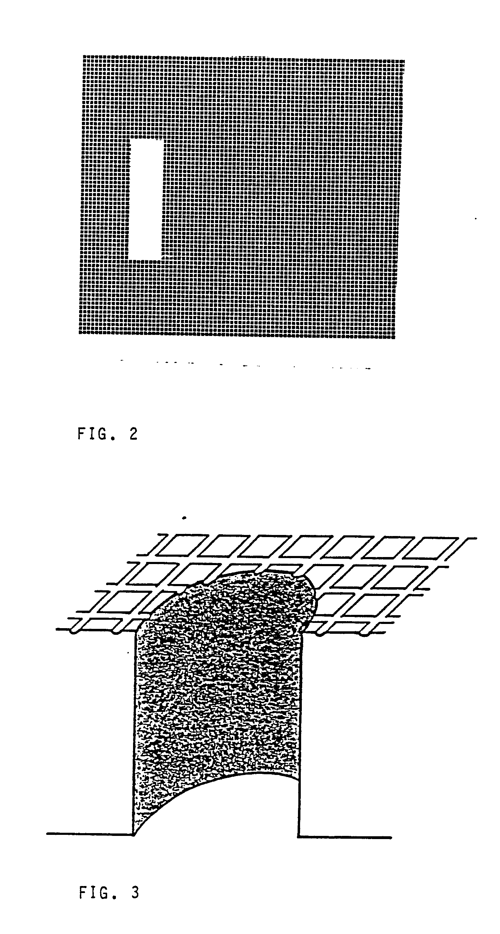

Fig. 2 zeigt die mit dem Kanal-Netzwerk versehene Metallkernplatte nach Fig. 1a mit einer rechteckigen Lochung, in welche eine Vielzahl von Kanälen mündet.

Fig. 3 stellt im Querschnitt eine zylindrische Lochung durch die mit dem Kanalnetz versehene Metallkernplatte dar.

Die Kanäle können beispielsweise im Ätzverfahren hergestellt werden. Dazu wird zunächst die Metallkernplatte mit einer im Photodruck hergestellten Ätzmaske ausgerüstet. Anschließend werden die Kanäle mittels eines Ätzprozesses ausgebildet und die Ätzmaske entfernt. Die Kanalstruktur kann beispielsweise auch durch Prägen oder nach einem anderen bekannten Verfahren hergestellt werden.

In einer Ausführungsform weist das Verfahren nach der Erfindung die folgenden Verfahrensschritte auf:

(1) Zuschneiden eines Aluminium-Metallkerns auf Maß;

(2) Reinigen der Oberfläche und beidseitiges Beschichten mit Trockenfilm-Photoresist (RISTON R 3315);

(3) Belichten der Photoresistschicht auf einer Seite durch die Kanalmuster-Vorlage, Entwickeln und damit Ausbilden der Ätzmaske;

(4) Ätzen der freiliegenden Metallkern-Oberfläche mit einer Cu(II)-chlorid-Lösung bis zu einer Tiefe von 0.035 mm;

(5) Entfernen der Photoresist-Ätzmaske;

(6) Herstellen von dem Lochmuster entsprechenden Bohrungen mit Bohrereintritt von der ungeätzten Metallkernseite; der Bohrdurchmesser ist gleich dem Nenndurchmesser der Lochungen plus 0.4 mm;

(7) Entgraten mit einer Cu(II)-chlorid-Lösung;

(8) Auflaminieren von Epoxidharz-Prepregs und Folienkupfer zunächst von der nicht mit Kanälen versehenen und anschließend von der anderen Plattenseite;

(9) Herstellen der Lochungen im Nenndurchmesser durch Bohren;

(10) Reinigen der Lochungen und Weiterbehandlung, wie für zweiseitige Leiterplatten an sich bekannt.

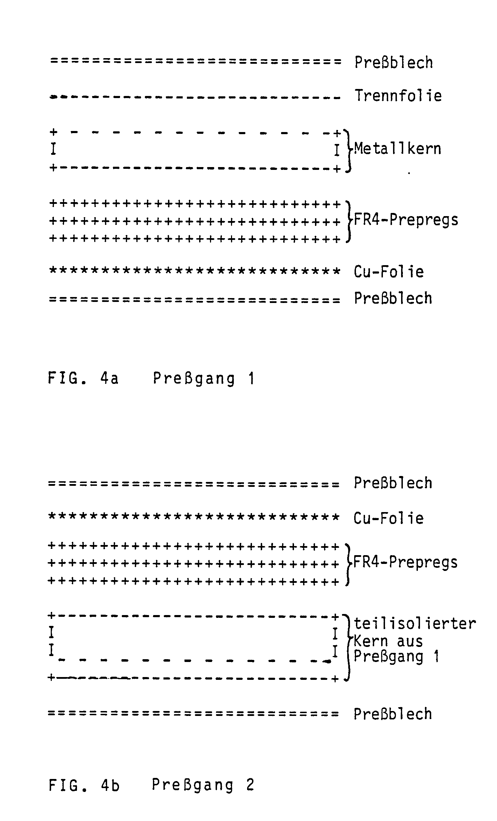

Der Verfahrensschritt (8) wird entsprechend der in den Fig. 4a und 4b dargestellten Anordnung von Metallkernplatte, Preßblech, Prepreg und Folienkupfer durchgeführt. Anstelle des Metallkerns aus Aluminium können andere, geeignete Metallkern-Materialien wie Eisen, Kupfer, Kupfer-Invar-Kupfer-Schichtstoffe verwendet werden.

Ein zusätzlicher Vorteil des beanspruchten Verfahrens besteht darin, daß durch die Kanalstruktur der Metallkern-Oberfläche ein verbesserter Wärmeübergang zwischen Isolierstoff und Metallkern bewirkt wird.

## Ansprüche

1. Verfahren zum Herstellen von einen plattenförmigen Metallkern aufweisenden Leiterplatten, bei welchem der Mettalkern mit ersten Lochungen versehen wird, diese mit Isolierstoff gefüllt und zugleich die Oberfläche der Metallkerns mit einer Isolierstoff-Schicht versehen wird, und sodann die mit Isolierstoff gefüllten Lochungen wieder gelocht werden, wobei der Durchmesser der zweiten Lochungen geringer ist als jener der ersten Lochungen, so daß eine Isolierstoff-Schicht in den Lochungen erhalten bleibt, **dadurch gekennzeichnet,** daß zumindest eine Seite des plattenförmigen Metallkerns zunächst mit einem Netz aus Kanälen versehen wird, sodann die ersten Lochungen hergestellt werden, dann der Metallkern mit einer Isolierstoff-Schicht verpreßt wird, wobei die Kanäle zur Luftabfuhr aus den Lochungen dienen und so eine vollständige und blasenfreie Füllung der Lochungen mit Isolierstoff erfolgt; und daß anschließend in einem späteren Arbeitsgang die zweiten Lochungen hergestellt werden.

2. Verfahren nach Anspruch 1, dadurch gekennzeichnet, daß das Netz aus Kanälen gitterartig angeordnet ist und der Abstand zwischen den Kanälen so bemessen wird, daß jede der ersten Lochungen auf ihrem Umfang mit einer Mehrzahl von Kanälen in Verbindung steht.

3. Verfahren nach Anspruch 1 oder 2, dadurch gekennzeichnet, daß die Kanäle eine Tiefe von 0.035 mm und eine Breite von 0.2 mm aufweisen und in einem Abstand von 0.8 mm von Kanalkante zu Kanalkante angeordnet sind.

4. Verfahren nach den Ansprüchen 1 bis 3, dadurch gekennzeichnet, daß die Kanäle mittels einer Photodruckmaske und Ätzen hergestellt werden.

5. Verfahren nach den Ansprüchen 1 bis 4, dadurch gekennzeichnet, daß die Isolierstoff-Schicht durch Verpressen von Prepreg aufgebracht wird.

6. Verfahren nach den Ansprüchen 1 bis 5, dadurch gekennzeichnet, daß zunächst eine Seite des Metallkerns und die ersten Lochungen mit einer Isolierstoff-Schicht versehen werden, und anschließend die zweite Seite des Metallkern beschichtet wird.

7. Verfahren nach Anspruch 6, dadurch gekennzeichnet, daß die oder eine der mit Kanälen versehene(n) Oberfläche(n) des Metallkerns mit einem Preßblech versehen und die andere Seite mit einem plattenförmigen Isolierstoff belegt und dieser unter Druck und Hitze in an sich bekannter Weise auflaminiert wird, wobei gleichzeitig unter Verdrängung der Luft aus den Lochungen über die Kanäle die Lochungen vollständig mit Isolierstoff gefüllt werden.

8. Verfahren nach Anspruch 7, dadurch gekennzeichnet, daß anschließend die zweite Seite des Metallkerns in an sich bekannter Weise mit Isolierstoff beschichtet wird.

9. Verfahren nach einem der Ansprüche 1 bis 8, dadurch gekennzeichnet, daß die Isolierstoff-Lochwandungen in an sich bekannter Weise mit einem Metallbelag versehen werden.

10. Einen Metallkern aufweisende Leiterplatte mit mit Isolierstoff gefüllten ersten Lochungen, die mit zweiten Lochungen versehen sind, wobei der Durchmesser der zweiten Lochungen geringer ist als der der ersten Lochungen, dadurch gekennzeichnet, daß der Metallkern mit einem Netz aus Kanälen versehen ist.

11. Leiterplatte nach Anspruch 10, dadurch gekennzeichnet, daß der äußere Umfang jeder Lochung mit einer Mehrzahl von Kanälen verbunden ist.

12. Leiterplatte nach Anspruch 10 oder 11, dadurch gekennzeichnet, daß die Kanäle mit Isolierstoff gefüllt sind.

FIG. 1a

0.2 mm

0.2 mm

0.8 mm

0.8 mm

FIG. 1b

FIG. 2

FIG. 3

```
============================= Preßblech

----------------------------- Trennfolie

+ - - - - - - - - - - - - -+ ⎫
I                         I ⎬Metallkern
+-------------------------+ ⎭

+++++++++++++++++++++++++++ ⎫
+++++++++++++++++++++++++++ ⎬FR4-Prepregs
+++++++++++++++++++++++++++ ⎭

*************************** Cu-Folie

============================= Preßblech
```

FIG. 4a    Preßgang 1

```
============================= Preßblech

*************************** Cu-Folie

++++++++++++++++++++++++++ ⎫
++++++++++++++++++++++++++ ⎬FR4-Prepregs
++++++++++++++++++++++++++ ⎭

+-------------------------+ ⎫teilisolierter
I                         I ⎬Kern aus
I_ - - - - - - - - - - - _I ⎪Preßgang 1
+-------------------------+ ⎭

============================= Preßblech
```

FIG. 4b    Preßgang 2